(19) Europäisches Patentamt / European Patent Office / Office européen des brevets

(11) **EP 4 682 780 A1**

(12) **EUROPEAN PATENT APPLICATION**

(43) Date of publication:
**21.01.2026 Bulletin 2026/04**

(21) Application number: **25189318.6**

(22) Date of filing: **14.07.2025**

(51) International Patent Classification (IPC):
**G06N 10/70** $^{(2022.01)}$ **G06N 10/20** $^{(2022.01)}$

(52) Cooperative Patent Classification (CPC):
**G06N 10/20; G06N 10/70**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.07.2024 JP 2024115052**

(71) Applicant: **Fujitsu Limited
Kawasaki-shi, Kanagawa 211-8588 (JP)**

(72) Inventor: **KATSUDA, Mitsuki
Kawasaki-shi, 211-8588 (JP)**

(74) Representative: **Haseltine Lake Kempner LLP
Cheapside House
138 Cheapside
London EC2V 6BJ (GB)**

(54) **NOISE SIMULATION PROGRAM, INFORMATION PROCESSING APPARATUS, AND NOISE SIMULATION METHOD**

(57) An information processing apparatus (1) performs noise simulation using a noise process of a quantum gate included in a quantum circuit. For example, after the processing by the quantum gate, the information processing apparatus (1) performs noise simulation by performing application, as the noise process, including applying the quantum gate by half in a reverse direction, adding time evolution derived from residual interaction, and applying the quantum gate by another half in a forward direction.

## FIG.4C

EP 4 682 780 A1

EP 4 682 780 A1

## Description

FIELD

The embodiment discussed herein is related to a noise simulation program and the like.

BACKGROUND

A quantum bit during execution of a quantum circuit has quantum errors derived from various factors. Examples of the quantum errors include a stochastic flip error derived from an interaction with a degree of freedom existing outside a quantum device and a coherent error derived from an extra interaction existing inside the quantum device. The quantum error generated in the quantum bit propagates through a quantum gate to cause statistical/systematic errors in the result of a quantum computation. Therefore, in order to examine a specific influence of the quantum error on the result of the quantum computation, it is preferable to perform noise simulation of examining the propagation of noise in the quantum circuit.

Known examples of noise simulation include an analysis using a quantum master equation. The quantum master equation is represented by the following Formula (1). In Formula (1), a time evolution of a state $\rho$ of an open quantum system is described by a Hamiltonian H and a relaxation operator $L_i$. Note that $\rho$ represents the state of the quantum device. H represents an internal interaction, and $L_i$ represents an external interaction. $\gamma_i$ represents the strength of the interaction.

$$\frac{d\rho(t)}{dt} = -i[H, \rho] + \sum_i \gamma_i \left( L_i \rho L_i^\dagger - \frac{1}{2}\{L_i L_i^\dagger, \rho\} \right) \qquad \cdots (1)$$

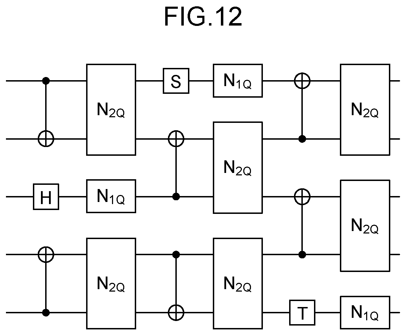

As another example of noise simulation, an analysis using a quantum circuit model is known. FIG. 12 is a diagram illustrating a reference example of noise model arrangement in a quantum circuit. For example, in the quantum circuit, a noise process $N_{1Q}$ is applied immediately after one quantum gate constituting the quantum circuit and a noise process $N_{2Q}$ is applied immediately after two quantum gates constituting the quantum circuit, thereby approximating the state after application of noise. That is, these applications achieve approximation of the influence of the quantum error on individual quantum bits.

Examples of related-art are described in Japanese National Publication of International Patent Application No. 2023-550324, Japanese Laid-open Patent Publication No. 2024-23156, US Patent Application Publication 2023/0016817, and William Berquist et al "Stochastic Approach For Simulating Quantum Noise Using Tensor Networks".

However, the conventional noise simulation has problems such as increased computation cost and a difficulty to enhance noise simulation accuracy in the quantum circuit.

For example, in the analysis using the quantum master equation, the dimensions of H, $L_i$, and $\rho$ exponentially increase with the number of quantum bits, increasing the cost of matrix computation associated with integration together with enlargement of the system.

In addition, the analysis using a quantum circuit model has the following problem. The action of noise proceeds simultaneously with the action of the quantum gate, and the nature of the noise changes depending on the quantum gate that acts simultaneously. For this reason, putting the noise into common categories such as $N_{1Q}$ and $N_{2Q}$, it would be difficult to incorporate the influence of a coherent error having changing nature due to interference with the quantum gate. That is, the accuracy of noise simulation of the quantum circuit is not to be enhanced.

SUMMARY

According to an aspect of an embodiment, an information processing apparatus is provided to perform noise simulation using a noise process of a quantum gate included in a quantum circuit. The information processing apparatus includes a control unit. The control unit performs noise simulation, the noise simulation being performed by first performing processing by the quantum gate, and then, performing application, as the noise process, including a process of applying the quantum gate by a half in a reverse direction, a process of adding time evolution derived from residual interaction, and a process of applying the quantum gate by another half in a forward direction.

BRIEF DESCRIPTION OF DRAWINGS

FIG. 1 is a diagram illustrating a schematic of noise model arrangement in a quantum circuit according to an exemplary embodiment;

FIG. 2 is a diagram illustrating a noise process according to the exemplary embodiment;

FIG. 3 is a diagram illustrating an example of a functional configuration of an information processing apparatus according to the exemplary embodiment;

FIG. 4A is a diagram (1) illustrating a noise process extraction technique according to the exemplary embodiment;

FIG. 4B is a diagram (2) illustrating the noise process extraction technique according to the exemplary embodiment;

FIG. 4C is a diagram (3) illustrating a noise process extraction technique according to the exemplary embodiment;

FIG. 5 is a diagram illustrating modeling of the noise process according to the exemplary embodiment;

FIG. 6 is a diagram illustrating an example of a flowchart of an overall noise simulation according to the exemplary embodiment;

FIG. 7 is a diagram illustrating an example of a flowchart of noise process extraction according to the exemplary embodiment;

FIG. 8A is a diagram (1) illustrating an example of noise process extraction according to the exemplary embodiment;

FIG. 8B is a diagram (2) illustrating an example of the noise process extraction according to the exemplary embodiment;

FIG. 8C is a diagram (3) illustrating an example of the noise process extraction according to the exemplary embodiment;

FIG. 8D is a diagram (4) illustrating an example of the noise process extraction according to the exemplary embodiment;

FIG. 9 is a diagram illustrating an example of a result of the noise simulation according to the exemplary embodiment;

FIG. 10 is a diagram illustrating another example of a result of the noise simulation according to the exemplary embodiment;

FIG. 11 is a diagram illustrating an example of a computer that executes a noise simulation program; and

FIG. 12 is a diagram illustrating a reference example of noise model arrangement in a quantum circuit.

## DESCRIPTION OF EMBODIMENTS

Preferred embodiments of the present invention will be explained with reference to accompanying drawings. The present invention is not limited to the exemplary embodiment.

Exemplary embodiment

Schematic of noise model arrangement

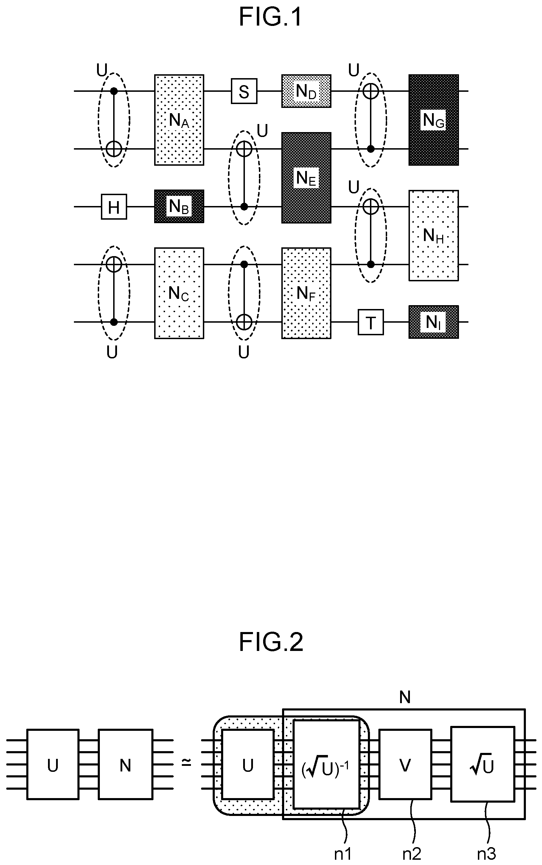

First, noise simulation in a quantum circuit according to an exemplary embodiment will be described with reference to FIG. 1. FIG. 1 is a diagram illustrating a schematic of noise model arrangement in the quantum circuit according to the exemplary embodiment. The noise simulation in the quantum circuit according to the exemplary embodiment examines propagation of noise in the quantum circuit using an individual noise processes for each quantum gate included in the quantum circuit. That is, the noise simulation analyzes the influence of the noise using an individual noise process of the quantum gate. The noise herein is denoted to represent a quantum error.

As illustrated in FIG. 1, for example, the noise simulation arranges individual noise processes $N_A$, $N_C$, $N_E$, $N_F$, $N_G$, and $N_H$ for a plurality of quantum gates U acting on two quantum bits. Subsequently, the noise simulation analyzes the influence of the noise (quantum error) using the individual noise processes arranged. Moreover, the noise simulation arranges individual noise processes $N_B$, $N_D$, and $N_I$ for a plurality of quantum gates H, S, and T acting on one quantum bit. Subsequently, the noise simulation analyzes the influence of the noise (quantum error) using the individual noise processes arranged.

Note that the noise simulation in the quantum circuit according to the exemplary embodiment performs an analysis by a noise process incorporating the characteristics of the quantum device. The noise process incorporating the characteristics of the quantum device refers to a Pauli channel. The Pauli channel herein refers to a noise process in which a Pauli error occurs randomly on a quantum bit in accordance with a certain probability distribution. The simulation using the Pauli channel has already been implemented by simulation software such as Qulacs (arXiv: 2011.13524). The Pauli channel will be described below.

Description of noise process

FIG. 2 is a diagram illustrating a noise process according to the exemplary embodiment. FIG. 2 illustrates a relationship between the quantum gate U and the noise process N acting after the processing.

The noise process N according to the exemplary embodiment is a process in which, after the processing by the quantum gate U (ideal quantum gate), the quantum gate U is applied by a half in a reverse direction $((\sqrt{U})^{-1})$, a time evolution V derived from residual interaction or relaxation is added, and then the quantum gate U is applied by another half in a forward direction $(\sqrt{U})$. The process of applying the quantum gate U by a half in the reverse direction is represented by a symbol n1. The time evolution V derived from residual interaction or relaxation is denoted by a symbol n2. The process of applying the quantum gate U by another half in the forward direction is represented by a symbol n3. While the time evolution V in the noise process N has been described as the time evolution derived from either the residual interaction or the relaxation for the time evolution V. However, the time evolution V is not limited thereto, and may be a time evolution derived from both the residual interaction and the relaxation.

Here, the residual interaction refers to an unwanted interaction existing between quantum bits. The noise derived from this action is a coherent error, for example. In addition, relaxation refers to interaction from the outside. The noise derived from this action is a stochastic flip error, for example.

The noise process N like this takes into account interference between the quantum gate U and the residual interaction or relaxation. That is, the noise process N interposes the rotation derived from residual interaction or relaxation between ideal time evolutions (n1 and n3), thereby enabling acquisition of mutually interfering components of U and V. This achieves better approximation than in the case of simply applying V as noise after U. Consequently, the noise process N applies V on an ongoing state of U instead of applying after the processing by U, making it possible to model the action of noise that proceeds simultaneously with the actual action of the quantum gate U.

Application of the noise process N like this to noise simulation will enable the quantum device to implement noise simulation under the noise model having a higher fidelity to the device performance, leading to enhancement of noise simulation accuracy.

Although FIG. 2 has illustrated a case where U is divided into two having a half in the reverse direction and another half in the forward direction, the type of division is not limited thereto. For example, U and V may be further finely divided by applying the result of Suzuki-Trotter decomposition (arXiv: math-ph/0506007).

Functional configuration of information processing apparatus

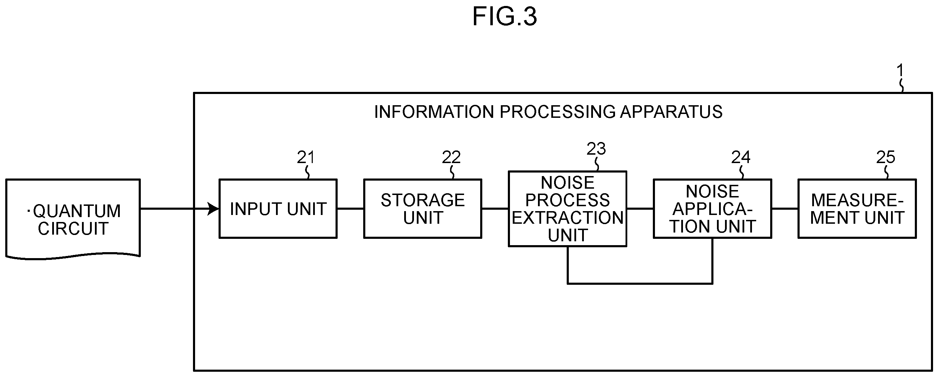

FIG. 3 is a diagram illustrating an example of a functional configuration of an information processing apparatus according to the exemplary embodiment. The information processing apparatus 1 illustrated in FIG. 3 is an example of a quantum device that performs noise simulation. The information processing apparatus 1 includes an input unit 21, a storage unit 22, a noise process extraction unit 23, a noise application unit 24, and a measurement unit 25.

The input unit 21 inputs information of the quantum circuit and the like and stores the information in the storage unit 22. The information of the quantum circuit refers to, for example, a quantum circuit described in a scheme of describing a circuit.

The storage unit 22 stores the information input by the input unit 21. In addition, the storage unit 22 stores intermediate information regarding the simulation performed by the noise process extraction unit 23 and the noise application unit 24 as well as information measured by the measurement unit 25.

The noise process extraction unit 23 extracts a noise process of the target quantum gate.

For example, the noise process extraction unit 23 selects one step of interest in the quantum circuit. The one step of interest includes a noise process of the target quantum gate to be modeled. Subsequently, the noise process extraction unit 23 approximates a process in one step selected in the quantum circuit, as a combination of quantum gates. That is, the noise process extraction unit 23 approximates "N" illustrated in the left diagram of FIG. 2 as a combination of quantum gates n1, n2, and n3 illustrated in the right diagram. Subsequently, the noise process extraction unit 23 extracts only the quantum gate related to the noise process of the target quantum gate among the approximated combinations of quantum gates. Subsequently, the noise process extraction unit 23 models the time evolution by the extracted quantum gate as a noise process of the target quantum gate. Here, the noise process extraction unit 23 uses the Pauli channel when modeling the noise process. That is, the noise process extraction unit 23 calculates the probability distribution of the occurrence probability of various types of Pauli errors for the quantum bit on which the noise process of the target quantum gate acts, so as to model the noise process as a noise process having the probability distribution of the occurrence probability.

Furthermore, the noise process extraction unit 23 sequentially sets another quantum gate included in the selected one step, as a target quantum gate, and extracts only a quantum gate related to the noise process of the target quantum gate. Subsequently, the noise process extraction unit 23 models the time evolution by the extracted quantum gate as a noise process of the target quantum gate. Subsequently, the noise process extraction unit 23 similarly models the noise process of each quantum gate included in the step for other steps in the quantum circuit. That is, the noise process extraction unit 23 models the noise process having the probability distribution of the occurrence probability individually for each target quantum gate.

The noise application unit 24 applies the noise process of the target quantum gate. For example, the noise application unit 24 randomly generates the Pauli error in accordance with the distribution of the occurrence probability of the Pauli error for the noise process of the target quantum gate modeled by the noise process extraction unit 23.

The measurement unit 25 measures a quantum bit. For example, the measurement unit 25 applies the noise process to all target quantum gates in the quantum circuit to measure the quantum bits included in the quantum circuit. That is, the measurement unit 25 measures the quantum bits in order to analyze the influence of noise on individual quantum bits. That is, the measurement unit 25 examines propagation of noise in the quantum circuit.

Noise process extraction technique

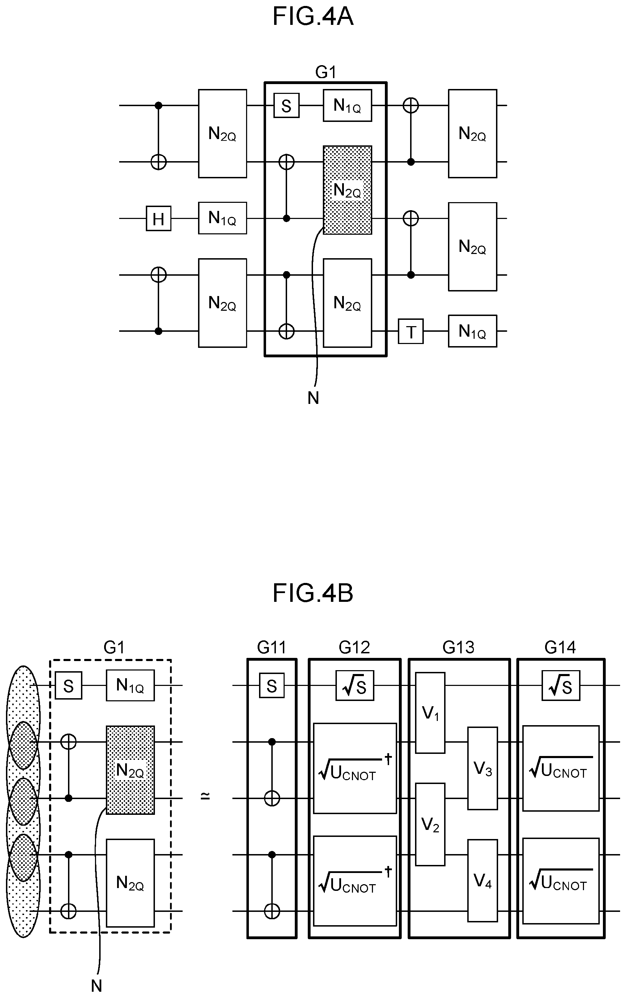

FIGS. 4A to 4C are diagrams illustrating a noise process extraction technique according to the exemplary embodiment. Here, for convenience of description, the number of the noise processes to be modeled is supposed to be one. In addition, the time evolution V is described as a time evolution derived from residual interaction as an example.

As illustrated in FIG. 4A, the noise process extraction unit 23 selects one step of interest in the quantum circuit. Here, the one step to be selected is denoted by a symbol G1. Step G1 includes a target quantum gate and a noise process N to be modeled.

As illustrated in FIG. 4B, the noise process extraction unit 23 approximates a process in one step selected in the quantum circuit, as a combination of the quantum gates. That is, the noise process extraction unit 23 performs approximation as a combination of a target quantum gate G11, a half G12 in the reverse direction of the target quantum gate, a time evolution G13 derived from the residual interaction, and another half G14 in the forward direction of the target quantum gate.

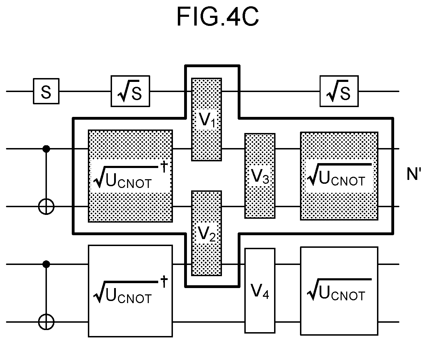

As illustrated in FIG. 4C, the noise process extraction unit 23 extracts the quantum gate related to the noise process N of the target quantum gate among the approximated combinations of quantum gates. Here, the quantum gates indicated by highlighting are extracted as the quantum gates related to the noise process N. Subsequently, the noise process extraction unit 23 models the time evolution by the extracted quantum gate as a noise process of the target quantum gate. The modeled noise process is denoted by a symbol N'. That is, the noise process extraction unit 23 approximates a noise process $N_{2Q}$ of the target quantum gate as a noise process N' to be modeled.

In the modeling, an analysis is performed using a Pauli channel incorporating the characteristics of the quantum device of the quantum device. The Pauli channel herein refers to a noise process in which a Pauli error occurs randomly on a quantum bit in accordance with a certain probability distribution. That is, when performing modeling, the noise process extraction unit 23 calculates the probability distribution of the occurrence probability of the Pauli error in the noise process N'. That is, by adjusting the probability distribution of the occurrence probability of the Pauli error, the noise process extraction unit 23 can incorporate the characteristics of the quantum error generated in the quantum system, enabling execution of noise simulation for the quantum circuit using the probability distribution.

Modeling of noise process

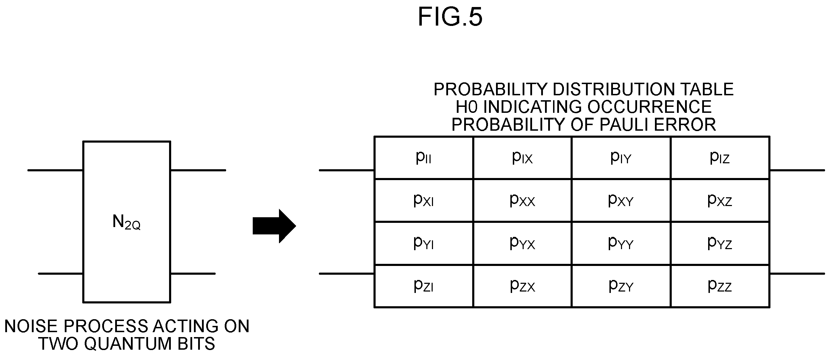

FIG. 5 is a diagram illustrating modeling of the noise process according to the exemplary embodiment. Here, a bit flip error or a phase flip error occurring in the quantum bit is described using a Pauli operator. A Pauli I operator corresponds to a case where no error occurs. A Pauli X operator corresponds to a bit flip error, the Pauli Z operator corresponds to a phase flip error, and a Pauli Y operator corresponds to a phase flip error of a correlated bit. When performing the modeling, the noise process extraction unit 23 calculates the probability of occurrence of each error. When the noise process N' to be modeled is one quantum bit, all four types of probabilities are calculated. When the noise process N' to be modeled is two quantum bits, all 16 types of probabilities are calculated.

In FIG. 5, $N_{2Q}$ is the case of a noise process N' that acts on two quantum bits. In such a case, the noise process extraction unit 23 performs an analysis using the Pauli channel to calculate probabilities of all 16 types of Pauli errors that can occur in the two quantum bits. As an example, $p_{II}$ indicates a probability of occurrence of no error in either of the two quantum bits. $p_{IX}$ indicates a probability of a case where no error occurs in the upper quantum bit but a bit flip error occurs in the lower quantum bit. $p_{XY}$ indicates a probability of a case where a bit determination error occurs in the upper quantum bit and a phase flip error occurs regarding a bit correlated with the lower quantum bit. More specifically, for example, $p_{XY}$ indicates an occurrence probability of a Pauli error represented by a tensor product of the Pauli X operator and the Pauli Y operator.

In this manner, when performing modeling, the noise process extraction unit 23 performs an analysis using the Pauli channel to calculate the probability distribution of a simultaneous occurrence probability of the Pauli error in the noise process $N_{2Q}$ (N'). FIG. 5 illustrates a probability distribution table H0 including results of the calculation. Thereafter, the noise application unit 24 performs probability sampling in accordance with the probability distribution table H0 to select one error, and applies the noise process $N_{2Q}$ (N') of the target quantum gate.

Flowchart of overall noise simulation

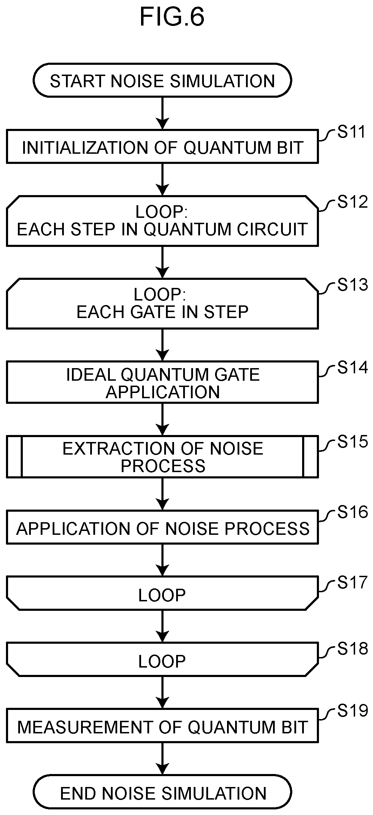

Here, an exemplary embodiment of a flowchart of an overall noise simulation according to the exemplary embodiment will be described with reference to FIG. 6. FIG. 6 is a diagram illustrating an example of a flowchart of an overall noise simulation according to the exemplary embodiment. Note that the information processing apparatus 1 is supposed to have input information of a quantum circuit and the like.

As illustrated in FIG. 6, the information processing apparatus 1 initializes all the quantum bits for the input quantum circuit (Step S11). The information processing apparatus 1 repeats Steps S13 to S17 for each step in the quantum circuit (Step S12).

The information processing apparatus 1 selects one step, and repeats Steps S14 to S16 for each quantum gate in the selected step (Step S13). The information processing apparatus 1 selects one quantum gate and applies the selected target quantum gate (ideal quantum gate) (Step S14). Subsequently, the information processing apparatus 1 extracts a noise process of the target quantum gate (Step S15). The processing of extracting the noise process will be described below.

Subsequently, the information processing apparatus 1 applies the extracted noise process (Step S16). Subsequently, when there is an unselected quantum gate in the selected steps, the information processing apparatus 1 proceeds to Step S13 (Step S17). When there is no unselected quantum gate in the selected step, the information processing apparatus 1 proceeds to Step S12 (Step S18).

When there is no unselected step, the information processing apparatus 1 measures all the quantum bits for the quantum circuit (Step S19). The information processing apparatus 1 ends the noise simulation.

Flowchart of noise process extraction

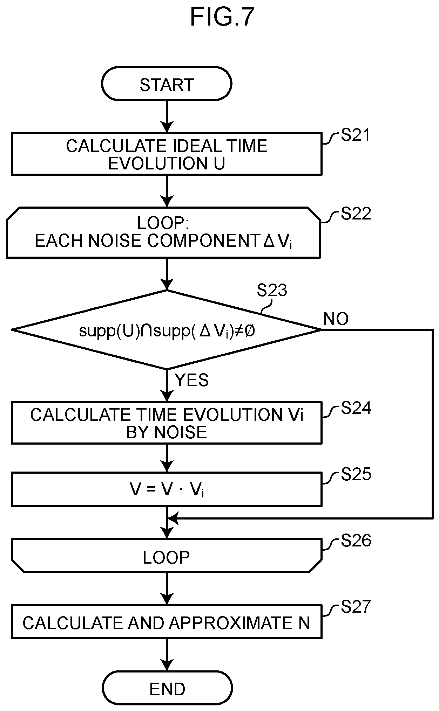

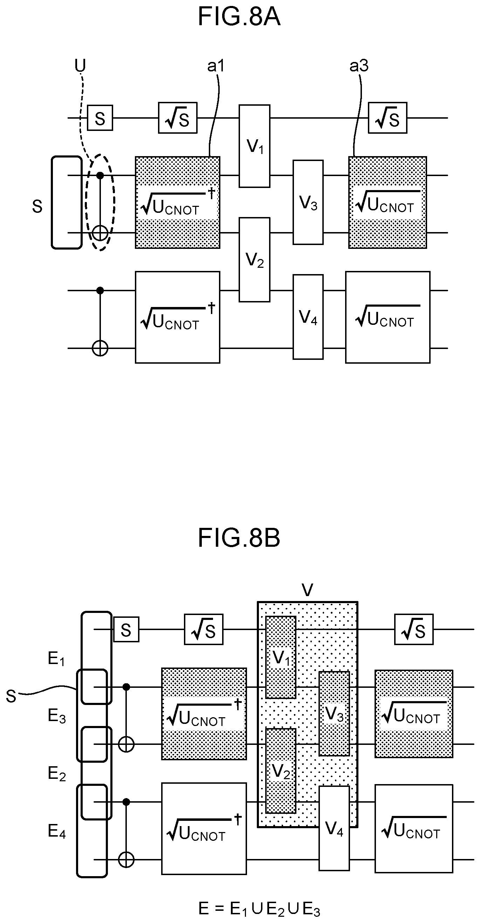

FIG. 7 is a diagram illustrating an example of a flowchart of noise process extraction according to the exemplary embodiment. The flowchart of FIG. 7 will be described with reference to FIGS. 8A to 8D. FIGS. 8A to 8D are diagrams illustrating an example of the noise process extraction according to the exemplary embodiment.

The information processing apparatus 1 calculates an ideal time evolution U for the target quantum gate (Step S21). Here, as illustrated in FIG. 8A, the quantum gate U acting on two quantum bits is defined as a target quantum gate. For example, the information processing apparatus 1 defines a set of quantum bits that undergo an action of the Pauli error P as S(=supp (P)) for the target quantum gate U. The information processing apparatus 1 calculates √U indicating the 1/2 power super-operator representation of the ideal quantum gate U and also calculates an inverse matrix of √U. √U is indicated by a symbol a3. The inverse matrix of √U is indicated by a symbol a1.

Returning to FIG. 7, the information processing apparatus 1 repeats Steps S23 to S25 for each noise component $\Delta V_i$ (Step S22). The information processing apparatus 1 determines whether a set of supp(U) and a set of supp($\Delta V_i$) are not empty sets (Step S23). That is, the information processing apparatus 1 determines whether the set S of quantum bits that undergo the action of the Pauli error P has an intersection. In a case where it is determined that the set of supp(U) and the set of supp($\Delta V_i$) are empty sets (Step S23; No), the information processing apparatus 1 proceeds to Step S26.

In contrast, when it is determined that the set of supp(U) and the set of supp($\Delta V_i$) are not empty sets (Step S23; Yes), the information processing apparatus 1 calculates a time evolution $V_i$ due to noise (Step S24). Subsequently, the information processing apparatus 1 calculates a product of the noise process V and the calculated $V_i$ (Step S25). When there is an unprocessed noise component $\Delta V_i$, the information processing apparatus 1 proceeds to Step S22 (Step S26). Here, as illustrated in FIG. 8B, the information processing apparatus 1 is supposed to calculate the noise process V related to the Pauli error P. At this time, the information processing apparatus 1 calculates a product only for j in which $E_j$ and S have an intersection as expressed in the following Formula (2). The target $V_j$ of Formula (2) is $V_1$, $V_2$, and $V_3$ illustrated in FIG. 8B. Subsequently, the information processing apparatus 1 defines a set E of quantum bits that undergo the action of the noise process V, as supp(V). The set E indicates a union of $E_1$, $E_2$, and $E_3$ illustrated in FIG. 8B.

$$ V = \prod_{\substack{j \\ E_j \cap S \neq \emptyset}} V_j = \prod_{\substack{j \\ E_j \cap S \neq \emptyset}} exp(\Delta V_j t) \qquad \cdots (2) $$

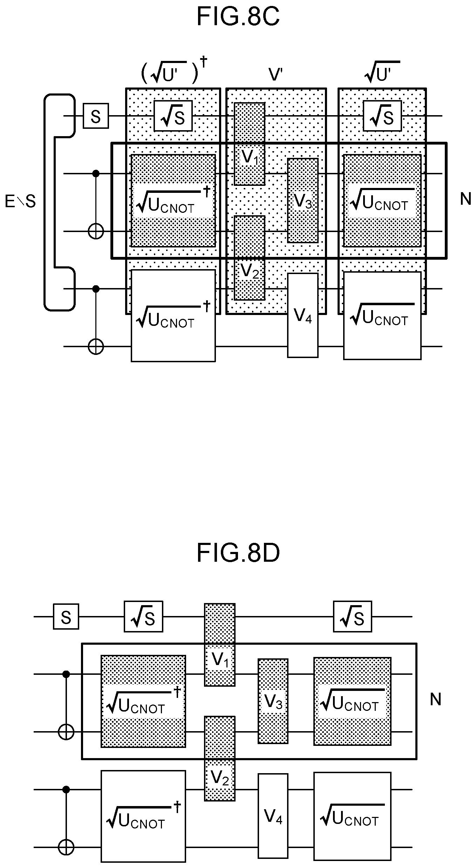

Returning to FIG. 7, when there is no unprocessed noise component $\Delta V_i$, the information processing apparatus 1 calculates the noise process N to implement approximation (Step S27). Here, as illustrated in FIG. 8C, the information processing apparatus 1 unifies the dimension of √U to $4^{|E|}$ by using a tensor product with an identity operator. Similarly, the information processing apparatus 1 unifies the dimensions of the inverse matrices of the noise processes V and √U to $4^{|E|}$. The value obtained by unifying the dimension of √U to $4^{|E|}$ is expressed as √U'. The dimension of the inverse matrix of √U unified to $4^{|E|}$ is expressed as (√U')$^{-1}$. The noise process V having its dimension unified to $4^{|E|}$ is represented as V'. Subsequently, the information processing apparatus 1 performs reduction of "(√U')$^{-1}$·V'·√U'", calculated as a noise process, for the component to act on Formula (8).

$$E \setminus S \qquad \cdots (8)$$

The noise process obtained as a result of the reduction is represented as N. The reduction refers to an operation of averaging components that change depending on the upper and lower states of the whole. By averaging, it is possible to obtain a relationship of only the middle without depending on the upper and lower states.

Here, details of the reduction operation will be described with reference to FIG. 8D. First, the information processing apparatus 1 defines the number of quantum bits that undergo an action of the quantum circuit, as "n". The information processing apparatus 1 calculates a super-operator $N_i$ representing the i-th noise as indicated by Formula (3).

$$\mathcal{N}_i = \left( \sqrt{\mathcal{U'}} \cdot \mathcal{V'} \cdot \left( \sqrt{\mathcal{U'}} \right)^\dagger \right) \cdot [P_i^T \otimes P_i] \qquad \cdots (3)$$

$P_i$ is an operator representing a transition and is defined as the following expression (4). Note that bit (i) is a symbol representing the j-th digit in the binary notation of i. I is a $2^n \times 2^n$ identity matrix. n is the number of quantum bits as described above.

$$P_i = \bigotimes_{j=0}^{|E \setminus S|-1} b_i, \quad b_i = \begin{cases} |0\rangle\langle \text{bit}_j(i)|, & (j \in E \setminus S) \\ I, & (\text{otherwise}) \end{cases} \qquad \cdots (4)$$

In a matrix representing the i-th noise $N_i$,
the information processing apparatus 1 takes a partial trace for the components acting on the quantum bit of

$$s \in E \setminus S \qquad \cdots (9) \qquad .$$

Subsequently, the information processing apparatus 1 obtains the sum of $N_i$ for the subscript i to calculate the noise process N.

Furthermore, the information processing apparatus 1 calculates Pauli-twirling approximation N^ of the reduced noise process N as expressed by the following Formula (5). That is, the calculated Pauli-twirling approximation N^ is a Pauli channel after approximation. Here, P is a Pauli error.

$$\widetilde{\mathcal{N}} = \sum_P (P \otimes P) \cdot \mathcal{N} \cdot (P \otimes P) \qquad \cdots (5)$$

Subsequently, the information processing apparatus 1 calculates a Pauli error occurrence probability $p_P$ as expressed in the following Formula (6). Here, $p_P$ represents the probability of occurrence of a specific Pauli error P among a total of $4^n$ (n is the number of quantum bits) Pauli errors. In order to calculate this probability, the sum of the right side equation of the right side $\Sigma$ is obtained for $4^n$ types of Pauli errors Q. The Pauli errors P and Q each refer to a tensor product in which n Pauli operators acting on each quantum bit are arranged.

$$p_P = \sum_Q \text{vec}(Q)^\dagger \cdot \widetilde{\mathcal{N}} \cdot \text{vec}(Q) \cdot (-1)^{\langle P, Q \rangle_{sp}} \qquad \cdots (6)$$

Note that $<P,Q>_{SP}$ in Formula (6) is also referred to as a symplectic inner product, and as illustrated in Formula (7), the value varies depending on the commutation relations of the Pauli operators P and Q.

$$\langle P, Q \rangle_{sp} = \begin{cases} 0, & (PQ - QP = 0) \\ 1, & (PQ - QP \neq 0) \end{cases} \qquad \cdots (7)$$

In this manner, the information processing apparatus 1 approximates the noise process of the target quantum gate as the noise process N to perform modeling, and calculates the probability distribution of the occurrence probability $p_P$ of the Pauli error P in the noise process N.

Returning to FIG. 7, the information processing apparatus 1 ends the noise process extraction processing.

Results of noise simulation

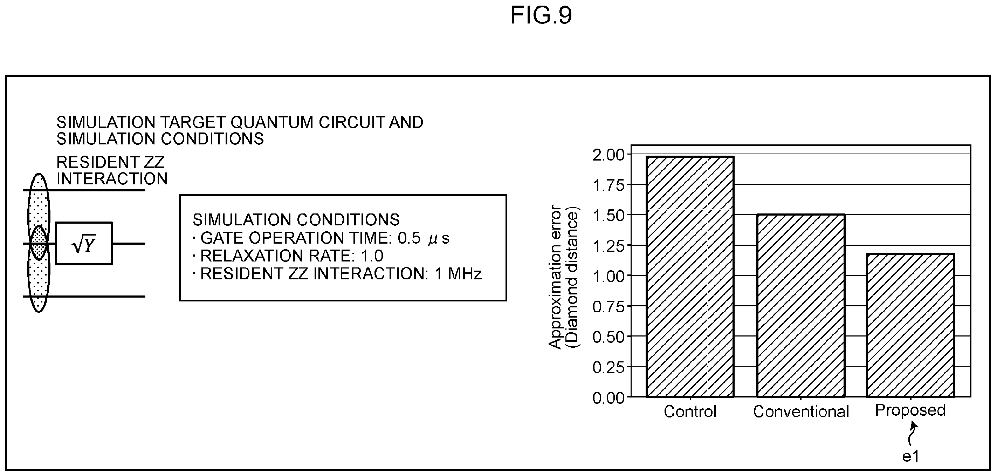

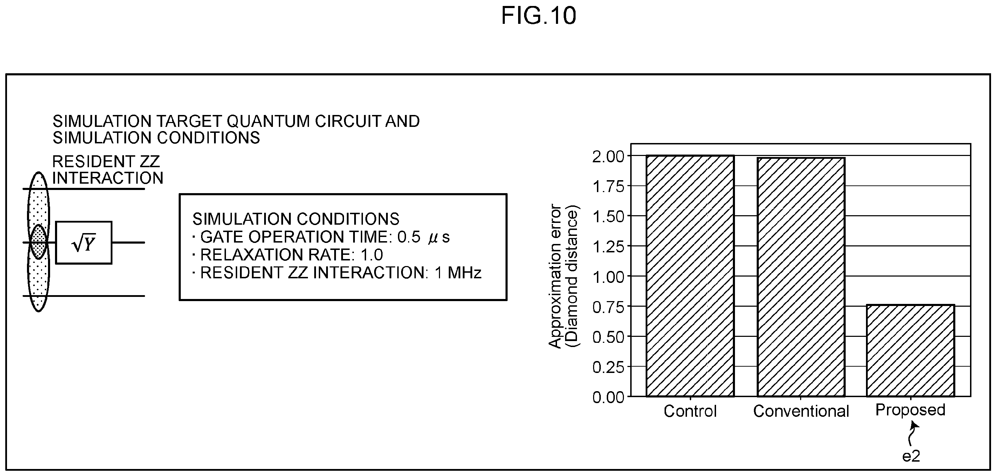

Next, a result of the noise simulation according to the exemplary embodiment will be described with reference to FIGS. 9 and 10. FIG. 9 is a diagram illustrating an example of a result of the noise simulation according to the exemplary embodiment. The left diagram of FIG. 9 illustrates a simulation target quantum circuit and simulation conditions. In FIG. 9, the information processing apparatus 1 simulates the influence of noise on the simulation target quantum circuit by three methods, and examines an approximation error, being a difference from strictly calculated time evolution. Such an approximation error is defined here by a diamond norm. The definition method using the diamond norm mentioned here is indicated by "Benenti, G. & Strini, G. Computing the distance between quantum channels: Usefulness of the Fano representation. J. Phys. B: At. Mol. Opt. Phys. 43, 215508 (2010)."

The three methods includes a case of performing no consideration of noise at all (Control), a case of using depolarizing noise (Conventional), and a case of using noise simulation according to the exemplary embodiment (Proposed). Note that the case of using depolarizing noise (conventional) is the case of using the noise simulation illustrated in FIG. 12. That is, the noise simulation in such a case is a method of applying the common noise process $N_{1Q}$ after the processing by the one quantum gate constituting the quantum circuit, and applying the common noise process $N_{2Q}$ after the processing by the two quantum gates.

The simulation conditions are a gate operation time of 0.5 $\mu$s, a relaxation rate of 1.0, and a resident ZZ interaction of 1 MHz. That is, the relaxation strength is higher than a predetermined value. In such a case, the case of using the noise simulation according to the exemplary embodiment indicated by a symbol e1 (Proposed) has a smaller approximation error than the case of not considering noise at all (Control) or the case of using depolarizing noise (Conventional).

FIG. 10 is a diagram illustrating another example of the result of the noise simulation according to the exemplary embodiment. The left diagram of FIG. 10 illustrates a simulation target quantum circuit and simulation conditions. In FIG. 10, similarly to FIG. 9, the information processing apparatus 1 simulates the influence of noise on the simulation target quantum circuit by three methods, and examines an approximation error, being a difference from strictly calculated time evolution. The three methods are as illustrated in FIG. 9.

The simulation conditions are set: a gate operation time of 0.5 $\mu$s, a relaxation rate of 0.1, and a resident ZZ interaction of 1 MHz. That is, the relaxation strength is lower than a predetermined value. In such a case, the case of using the noise simulation according to the exemplary embodiment indicated by a symbol e2 (Proposed) has a further suppressed (lower than FIG. 9) approximation error, compared with the case of not considering noise at all (Control) or the case of using depolarizing noise (Conventional). That is, it is possible to confirm that errors derived from residual interaction and relaxation can be better approximated when the influence of relaxation is lower and the resident ZZ interaction is higher.

In this manner, in a performance estimation of the quantum computation using noise simulation, the information processing apparatus 1 can perform evaluation more fitted to the characteristics of the actual quantum device as compared with the case of using the depolarizing noise (conventional) introduced by the conventional noise model.

Effects of exemplary embodiment

According to the above exemplary embodiment, the information processing apparatus 1 performs noise simulation using the noise process of the quantum gate included in the quantum circuit. For example, after the processing by the quantum gate, the information processing apparatus 1 performs noise simulation by performing application, as the noise process, including applying the quantum gate by half in the reverse direction, adding time evolution derived from residual interaction, and applying the quantum gate by another half in the forward direction. With this configuration, in which the time evolution derived from the residual interaction is interposed between the time evolutions of the ideal quantum gate, the information processing apparatus 1 can enhance the noise simulation accuracy more than the case of simply applying the noise process after the target quantum gate. In addition, even with an increased number of quantum bits in the quantum circuit, the information processing apparatus 1 can enhance the accuracy of the noise simulation of each quantum circuit while suppressing the computation cost.

Furthermore, the process of performing noise simulation in the information processing apparatus 1 includes approximation, in the quantum circuit, of a process in one step including the noise process of the target quantum gate, as a combination of the quantum gates included in the one step. Subsequently, the processing of performing the noise simulation extracts the quantum gate related to the noise process of the target quantum gate, from the approximated combination of the quantum gates, and then models the time evolution corresponding to the extracted quantum gate, as a noise process of the target quantum gate. Subsequently, the processing of performing the noise simulation generates noise using the modeled noise process. With this configuration of modeling the noise process of the target quantum gate included in one step of interest, the information processing apparatus 1 can enhance the accuracy of the noise simulation.

Furthermore, the modeling processing in the information processing apparatus 1 uses the Pauli operator to calculate a probability distribution in which various types of Pauli errors occur with respect to the quantum bit that undergoes an action of the noise process of the target quantum gate. Subsequently, the processing of generating noise randomly generates a Pauli error in accordance with the calculated probability distribution. This makes it possible for the information processing apparatus 1 to incorporate the characteristics of the error occurring in the quantum circuit by adjusting the distribution of the occurrence probability of the Pauli error using the Pauli channel in the noise process.

Furthermore, the modeling processing in the information processing apparatus 1 models each noise process for each target quantum gate included in the quantum circuit. With this configuration of individually using the noise process for each quantum gate instead of using common noise processes, the information processing apparatus 1 can enhance the noise simulation accuracy.

Furthermore, the process of performing the noise simulation in the information processing apparatus 1 performs the noise simulation using a noise process in which the time evolution derived from the residual interaction has been replaced with the time evolution derived from relaxation. With this configuration in which the time evolution derived from the relaxation is interposed between the time evolutions of the ideal quantum gate, the information processing apparatus 1 can enhance the accuracy of the noise simulation more than simply applying the noise process after the target quantum gate. In addition, even with an increased number of quantum bits in the quantum circuit, the information processing apparatus 1 can enhance the accuracy of the noise simulation of each quantum circuit while suppressing the computation cost.

Each of components of the information processing apparatus 1 in the figures allows other configurations, different from the physical configurations in the figures. In other words, specific forms of distribution/integration of the information processing apparatus 1 are not limited to the forms in the figures. All or part of them may be configured in a functionally or physically distributed/integrated form in an arbitrary unit, according to various types of loads and status of use, or the like. Furthermore, the storage unit 22 may be provided an external apparatus of the information processing apparatus 1, connected via a network.

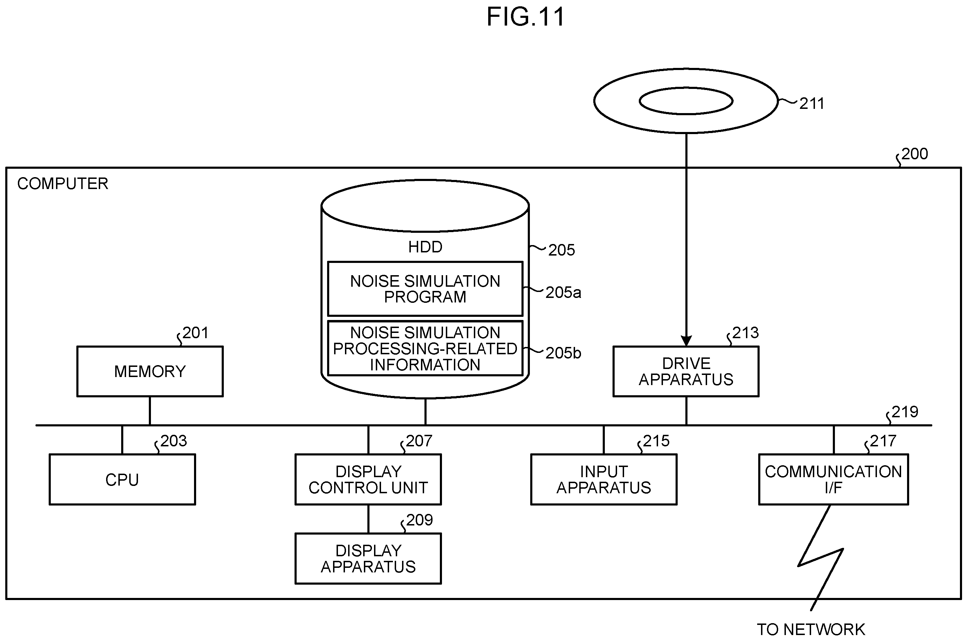

The various types of processing described in the above-described exemplary embodiment can be achieved by executing a prepared program on a computer such as a personal computer and a workstation. Accordingly, the following will describe an example of a computer that executes a noise simulation program that implements functions similar to those of the information processing apparatus 1 illustrated in FIG. 3. Here, a noise simulation program that implements a function similar to that of the information processing apparatus 1 will be described as an example. FIG. 11 is a diagram illustrating an example of a computer that executes a noise simulation program.

As illustrated in FIG. 11, a computer 200 includes: a central processing unit (CPU) 203 that executes various types of arithmetic processing; an input apparatus 215 that receives an input of data from a user; and a display apparatus 209. The computer 200 further includes: a drive apparatus 213 that reads a program and the like from a storage medium; and a communication interface (I/F) 217 that exchanges data with another computer via a network. The computer 200 further includes: memory 201 that temporarily stores various types of information; and a hard disk drive (HDD) 205. The memory 201, the CPU 203, the HDD 205, a display control unit 207, the display apparatus 209, the drive apparatus 213, the input apparatus 215, and the communication I/F 217 are interconnected by a bus 219.

The drive apparatus 213 is an apparatus for driving a removable disk 211, for example. The HDD 205 stores a noise simulation program 205a and noise simulation processing-related information 205b. The communication I/F 217 manages an interface between the network and the inside of the apparatus, and controls input/output of data with another computer. The communication I/F 217 may be implemented by adopting a device such as a modem, a LAN adapter, for example.

The display apparatus 209 is a display apparatus that displays data such as a document, an image, and functional information, including a cursor, an icon, or a tool box. The display apparatus 209 can be implemented by adopting a display such as a liquid crystal display and an organic electroluminescence (EL) display.

The CPU 203 reads the noise simulation program 205a, develops the program into the memory 201, and executes the program as a process. Such a process corresponds to each functional unit of the information processing apparatus 1. The noise simulation processing-related information 205b includes, for example, information stored in the storage unit 22. Subsequently, for example, the removable disk 211 stores each piece of information such as the noise simulation program 205a.

The noise simulation program 205a may be stored in a manner other than being stored in the HDD 205 from the beginning. For example, it is possible to configure such that each of the programs are stored in a "portable physical medium" to be inserted to the computer 200, such as a flexible disk (FD), a CD-ROM, a DVD, a magneto optical disk, and an IC card. The computer 200 may read the noise simulation program 205a from the medium and may execute the program.

The noise simulation described in the above exemplary embodiment can be applied to a case of evaluating computation performance by a quantum computer, for example.

According to one aspect of embodiment, it is possible to enhance the noise simulation accuracy in individual quantum circuits while suppressing computation cost.

**Claims**

1. A noise simulation program provided to perform noise simulation using a noise process of a quantum gate included in a quantum circuit,
the noise simulation program causing a computer to execute processing of performing noise simulation, the noise simulation being performed by first performing processing by the quantum gate, and then, performing application, as the noise process, including applying the quantum gate by half in a reverse direction, adding time evolution derived from residual interaction, and applying the quantum gate by another half in a forward direction.

2. The noise simulation program according to claim 1, wherein the process of performing noise simulation includes:

   approximating, in the quantum circuit, a process in one step including the noise process of a target quantum gate, as a combination of the quantum gates included in the one step;
   extracting a quantum gate related to the noise process of the target quantum gate among the approximated combinations of quantum gates, and modeling time evolution corresponding to the extracted quantum gate as the noise process of the target quantum gate; and
   generating noise using the modeled noise process.

3. The noise simulation program according to claim 2, wherein the modeling processing uses a Pauli operator to calculate a probability distribution regarding occurrence of various types of Pauli errors in a quantum bit that undergoes an action of the noise process of the target quantum gate, and
the processing of generating the noise randomly generates the Pauli error in accordance with the calculated probability distribution.

4. The noise simulation program according to claim 2 or claim 3, wherein the processing of modeling includes modeling of each of the noise processes for each target quantum gate included in the quantum circuit.

5. The noise simulation program according to any preceding claim, wherein the processing of performing noise simulation includes performing noise simulation using the noise process in which time evolution derived from the residual interaction has been replaced with time evolution derived from relaxation.

6. An information processing apparatus (1) provided to perform noise simulation using a noise process of a quantum gate included in a quantum circuit,
the information processing apparatus comprising a control unit (23, 24) that performs noise simulation, the noise simulation being performed by first performing processing by the quantum gate, and then, performing application, as the noise process, including a process of applying the quantum gate by a half in a reverse direction, a process of adding time evolution derived from residual interaction, and a process of applying the quantum gate by another half in a forward direction.

7. A noise simulation method provided to perform noise simulation using a noise process of a quantum gate included in a quantum circuit,
the noise simulation method performed by a computer to execute processing of performing noise simulation, the noise simulation being performed by first performing processing by the quantum gate, and then, performing application, as the noise process, including a process of applying the quantum gate by a half in a reverse direction, a process of adding time evolution derived from residual interaction, and a process of applying the quantum gate by another half in a forward direction.

FIG.1

FIG.2

EP 4 682 780 A1

# FIG.3

INFORMATION PROCESSING APPARATUS 1

QUANTUM CIRCUIT → INPUT UNIT (21) — STORAGE UNIT (22) — NOISE PROCESS EXTRACTION UNIT (23) — NOISE APPLICATION UNIT (24) — MEASUREMENT UNIT (25)

# FIG.4A

# FIG.4B

# FIG.4C

FIG.5

PROBABILITY DISTRIBUTION TABLE H0 INDICATING OCCURRENCE PROBABILITY OF PAULI ERROR

NOISE PROCESS ACTING ON TWO QUANTUM BITS

# FIG.6

```
START NOISE SIMULATION

INITIALIZATION OF QUANTUM BIT          S11

LOOP:
EACH STEP IN QUANTUM CIRCUIT           S12

LOOP:
EACH GATE IN STEP                      S13

IDEAL QUANTUM GATE
APPLICATION                            S14

EXTRACTION OF NOISE
PROCESS                                S15

APPLICATION OF NOISE PROCESS           S16

LOOP                                   S17

LOOP                                   S18

MEASUREMENT OF QUANTUM BIT             S19

END NOISE SIMULATION
```

## FIG.7

START

CALCULATE IDEAL TIME EVOLUTION U — S21

LOOP: EACH NOISE COMPONENT $\Delta V_i$ — S22

$supp(U) \cap supp(\Delta V_i) \neq \varnothing$ — S23

NO

YES

CALCULATE TIME EVOLUTION Vi BY NOISE — S24

$V = V \cdot V_i$ — S25

LOOP — S26

CALCULATE AND APPROXIMATE N — S27

END

## FIG.8A

## FIG.8B

$$E = E_1 \cup E_2 \cup E_3$$

# FIG.8C

# FIG.8D

# FIG.9

SIMULATION TARGET QUANTUM CIRCUIT AND
SIMULATION CONDITIONS

RESIDENT ZZ
INTERACTION

$\sqrt{Y}$

SIMULATION CONDITIONS
· GATE OPERATION TIME: 0.5 $\mu$s
· RELAXATION RATE: 1.0
· RESIDENT ZZ INTERACTION: 1 MHz

EP 4 682 780 A1

# FIG.10

SIMULATION TARGET QUANTUM CIRCUIT AND
SIMULATION CONDITIONS

RESIDENT ZZ
INTERACTION

$\sqrt{Y}$

SIMULATION CONDITIONS
· GATE OPERATION TIME: 0.5 $\mu$ s
· RELAXATION RATE: 1.0
· RESIDENT ZZ INTERACTION: 1 MHz

EP 4 682 780 A1

# FIG.11

COMPUTER 200

HDD 205
NOISE SIMULATION PROGRAM 205a
NOISE SIMULATION PROCESSING-RELATED INFORMATION 205b

211

MEMORY 201

CPU 203

DISPLAY CONTROL UNIT 207

DISPLAY APPARATUS 209

DRIVE APPARATUS 213

INPUT APPARATUS 215

COMMUNICATION I/F 217

219

TO NETWORK

EP 4 682 780 A1

FIG.12

Europäisches
Patentamt
European
Patent Office
Office européen
des brevets

# EUROPEAN SEARCH REPORT

**Application Number**

EP 25 18 9318

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Giovanni Di Bartolomeo ET AL: "A novel approach to noisy gates for simulating quantum computers", arXiv.org, 20 September 2023 (2023-09-20), pages 1-21, XP093335204, DOI: 10.48550/arxiv.2301.04173 Retrieved from the Internet: URL:https://arxiv.org/pdf/2301.04173 [retrieved on 2025-11-12] * abstract * * page 1, left-hand column, line 1 - page 19, right-hand column, last line * | 1-7 | INV. G06N10/70 G06N10/20 |
| A | Wang Meng ET AL: "TQSim: A Case for Reuse-Focused Tree-Based Quantum Circuit Simulation", arXiv.org, 25 March 2022 (2022-03-25), pages 1-13, XP093334779, Retrieved from the Internet: URL:https://arxiv.org/pdf/2203.13892v1 [retrieved on 2025-11-12] * abstract * * page 1, left-hand column, line 1 - page 12, left-hand column, line 12 * | 1-7 | |
| | | | **TECHNICAL FIELDS SEARCHED (IPC)** G06N |

The present search report has been drawn up for all claims

| Place of search | Date of completion of the search | Examiner |
|---|---|---|
| The Hague | 3 December 2025 | Totir, Felix |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023550324 A
- JP 2024023156 A

- US 20230016817

**Non-patent literature cited in the description**

- **WILLIAM BERQUIST et al.** *Stochastic Approach For Simulating Quantum Noise Using Tensor Networks*

- **BENENTI, G.** ; **STRINI, G.** Computing the distance between quantum channels: Usefulness of the Fano representation. *J. Phys. B: At. Mol. Opt. Phys.*, 2010, vol. 43, 215508